# EUROPEAN PATENT APPLICATION

(11) **EP 3 038 153 A1**
(43) Date of publication of application: **29.06.2016**
(21) Application number: 14307152.0
(22) Date of filing: 23.12.2014
(51) Int. Cl.: H01L 23/42

(54) **Method for attaching a thermal pad to a heat sink, corresponding heat sink and electronic card**

(71) Applicant: Thomson Licensing, 92130 Issy-les-Moulineaux (FR)
(72) Inventor: Martin, Pierrick, 35576 Cesson-Sévigné (FR); Le Foulgoc, Jean-Marc, 35576 Cesson-Sévigné (FR); Caban, Didier, 35576 Cesson-Sévigné (FR)
(74) Representative: Huchet, Anne

(57) **Abstract**

The present disclosure relates to a method for attaching at least a changing state pad to a heat sink configured to be mounted with at least an electronic chip.
According to a particular embodiment, said method comprises:
- heating said heat sink to at least a given temperature, bringing said heat sink to a heated state;
- positioning, while said heat sink is in said heated state, at least a first part of said changing state pad in contact with at least a surface of said heated heat sink, said surface being intended to face said chip once mounted.

## Description

### 1. Domain of the present disclosure.

The present disclosure relates to the domain of manufacturing of electronic cards, especially electronic cards to be equipped with a least a thermal dissipator, or heat sink. More specifically, the present disclosure relates to a method for attaching a thermal pad on a heat sink configured to be mounted with an electronic chip.

The context of the present disclosure is the thermal protection of chips equipping an electronic card. The thermal protection is commonly achieved by mounting of a heat sink on a chip, for thermal dissipation. However, the surface of the chip and the surface of the heat sink, facing each other, often have irregularities. Such irregularities may lower the thermal conductivity of the heat sink as they may be filled by air, known as a thermal insulating material.

The use of a thermal pad (also called "gap pad") provides continuous contact between the surfaces of the chip and the heat sink facing each other, despite of the irregularities, by filling the gap between both surfaces with a conductive material.

Several prior art solutions have been used by manufacturers for the positioning of such a pad between a chip and a heat sink.

A first solution consists in sticking the pad with an adhesive on the heat sink before the mounting of the latter. However, the presence of an adhesive (even if made of conductive material) raises the thickness of the pad and then lowers the thermal conducting properties of the pad. Thus, complementary thermal dissipation means (like a fan) are often required, thus raising the material cost and size of the equipped electronic card. For all that reasons, technical specifications sometimes prevent from using a pad with adhesive materials.

Another solution consists in using a changing state pad. A changing state pad has the property of being in a solid state at atmospheric temperature condition, and of being in a liquid state, or at least a melting state, at high temperature. When the electronic card is working, the heat released by the chip - on which the changing state pad is mounted - makes the changing state pad melt. The melted pad thus files irregularities between the chip and the heat sink, which assures a good thermal conductivity.

However, such a pad needs to be manually installed on the chip to be thermally protected, before the mounting of the heat sink on the chip. This solution is thus costly in time and may lead to wrong/poor positioning of the pad, or to an irregular thickness of the pad when melted, lowering the thermal conductivity of the latter.

### 2. Summary of the present disclosure.

The present disclosure addresses at least some of the above mentioned drawbacks.

More specifically, the present disclosure relates to a method for attaching at least a changing state pad to a heat sink configured to be mounted with at least an electronic chip.

According to an embodiment of the invention, said attaching method comprises:
- heating said heat sink to at least a given temperature, bringing said heat sink to a heated state;
- positioning, while said heat sink is in said heated state, at least a first part of said changing state pad in contact with at least a surface of said heated heat sink, said surface being intended to face said chip once mounted.

A changing state pad is defined here as being a thermal pad being in a solid state in an atmospheric temperature and being in a melting state at hot temperature like the temperature of the surface of the chip during the operating of the chip.

One of the general principles of the present disclosure is to perform an attaching of at least a changing state pad to a heat sink, prior to the installation of the heat sink in an installation position in which it protects at least a chip, for instance a chip equipping an electronic card. Such an electronic card may for instance become part of an electronic device, for instance a Set Top Box, a computer, a gateway, a TV set, a display etc...

According to an embodiment of the present disclosure, at said given temperature, the changing state pad becomes, at least partially, soft enough to stick to the facing surface of the heat sink.

According to an embodiment of the present disclosure, said given temperature belongs to the interval [50°C; 70°C].

According to an embodiment of the present disclosure, said attaching method comprises cooling at least said surface of said heat sink and/or said first part of said positioned pad, in order to put said first part in a solid state.

According to an embodiment of the present disclosure, said positioning is performed prior to mounting said heat sink on a chip.

According to an embodiment of the present disclosure, in said heated state, the heat sink is adapted for keeping a second part of said changing state pad, distinct from said first part, in a solid state.

According to an embodiment of the present disclosure, said changing state pad comprises at least a material belonging the group constituted of:
- fiber glass;
- Hot setting wax;
- Carrier material.

According to an embodiment of the present disclosure, said positioning is performed by an automatic tool.

According to an embodiment of the present disclosure, said heating is performed by heating said heat sink in a steamer.

According to an embodiment of the present disclosure, said heating is performed by blowing of hot air on at least said surface of said heat sink.

According to another aspect, the present disclosure relates to a heat sink configured to be mounted with an electronic chip.

Such a heat sink may be obtained by at least an embodiment of the attaching method of the present disclosure.

According to an embodiment of the present disclosure, said heat sink comprises a changing state pad attached to said heat sink while said heat sink is in a heated state, in which it has at least a given temperature, at least a first part of said changing state pad being positioned in contact with at least a surface of said heated heat sink, said surface being intended to face said chip once mounted.

According to another aspect, the present disclosure relates to an electronic card wherein said electronic card comprises at least an electronic chip and at least a heat sink mounted with said electronic chip.

Such a heat sink may be obtained by at least an embodiment of the attaching method of the present disclosure.

According to an embodiment of the present disclosure, said heat sink comprises a changing state pad attached to said heat sink prior to any operation of said electronic card, while said heat sink was in a heated state, in which it has at least a given temperature, at least a first part of said changing state pad being positioned in contact with at least a surface of said heated heat sink facing said chip once mounted with said chip.

According to another aspect, the present disclosure relates to an electronic device comprising at least an electronic card comprising at least an electronic chip and at least a heat sink mounted with said electronic chip.

Such a heat sink may be obtained by at least an embodiment of the attaching method of the present disclosure.

According to an embodiment of the present disclosure, said heat sink comprises a changing state pad attached to said heat sink prior to any operation of said electronic card, while said heat sink was in a heated state, in which it has at least a given temperature, at least a first part of said changing state pad being positioned in contact with at least a surface of said heated heat sink facing said chip once mounted with said chip.

While not explicitly described, the present embodiments may be employed in any combination or sub-combination. For example, some embodiments may involve an attaching method wherein said heating is performed by heating said heat sink in a steamer and where a cooling of the heat sink and/or the positioned pad is performed.

### 3. List of figures.

The present disclosure will be better understood, and other specific features and advantages will emerge upon reading the following description, the description making reference to the annexed drawings wherein:
- Figure 1A illustrates the heating of a batch of heat sinks, according to a particular embodiment of the present disclosure;
- Figure 1B illustrates the positioning of a changing state according to a particular embodiment of the present disclosure;
- Figure 2 shows a schematic view of the attaching method according to a particular embodiment of the present disclosure.

In all figures, the same element is being attributed the same literal reference.

### 4. Detailed description of the embodiments of the present disclosure.

According to at least an embodiment, the attaching method comprises a heating of the heat sink and a positioning of a changing state pad to be attached, on the heated heat sink, in order for the pad to become soft, rather than rigid, and naturally stick to the heat sink. The attached heat sink may then be mounted automatically on the chip.

The heat sink may notably be a plate heat sink or a heat sink comprising fins, blades, and/or stubs.

The pad may notably be a changing state pad with good thermal conducting properties (good conductivity, low thermal resistivity, ...), like a pad of type PCM471 built by the firm Keratherm®.

In some embodiments, the same heat sink may be adapted to protect several chips equipping the electronic card.

This heating of the heat sink, prior to its mounting with a chip, goes at the opposite of the preconception of the one skilled in the art, who is incited to avoid generating great variations of temperature on a mechanical element, in order to avoid of a premature aging of the element.

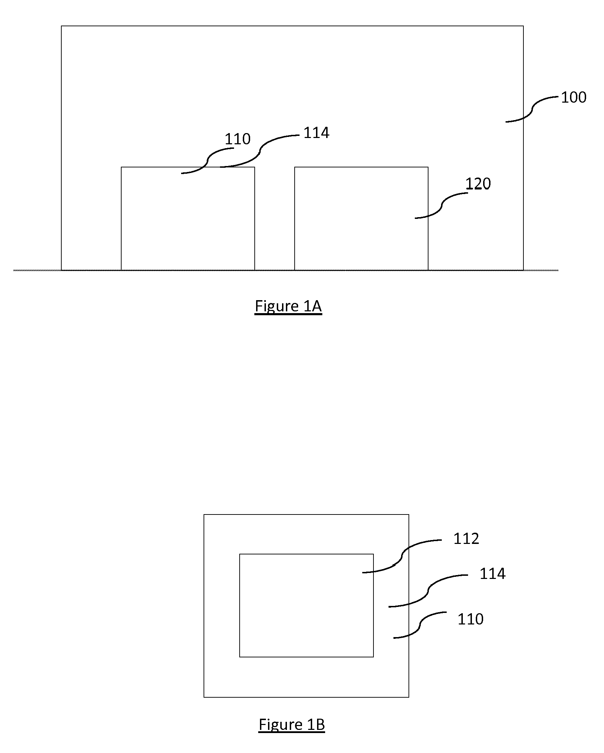

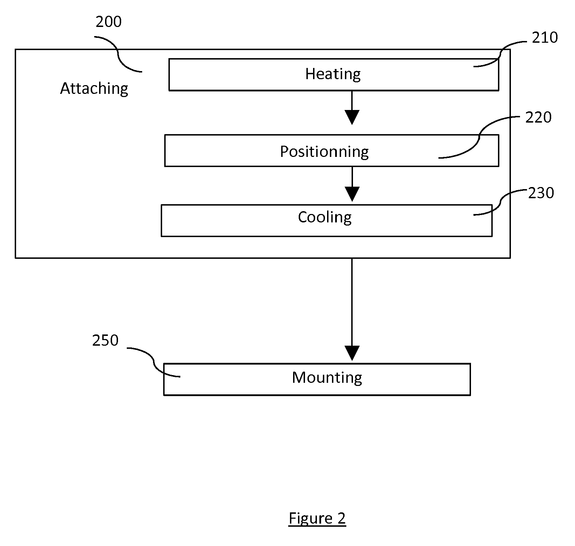

A particular embodiment of the attaching method 200 will now be presented, in association with figures 1A, 1B and 2.

According to the particular illustrated embodiment, the attaching method 200 is implemented on a heat sink (110,120) to be mounted on a chip equipping an electronic card. Depending upon embodiments, the heat sink may be installed for instance beyond the chip (and thus mounted after the chip eventually) or above the chip, on the electronic card.

According to the embodiment illustrated by figure 2, the attaching method 200 comprises a heating 210 of at least a heat sink (110, 120). Depending upon embodiments, the heating 210 may be performed thanks to at least a manual or automatic tool. Notably, it may be performed thanks to an air blowing tool (for instance in order to heat only a part of the heat sink) or, as illustrated by figure 1A, thanks to a steamer 100 (in order to get a uniform heating temperature distribution, to control more precisely the heating temperature and/or to obtain a better repeatability of the method for instance).

According to the illustrated embodiment, the heat sink (110, 120) (or at least a part of a surface 114 on which the pad is to be positioned) is heated at least at a given temperature. This heating temperature may vary, for instance upon the type of pad to be used, and/or the size, the shape and/or the material of the heat sink.

In the illustrated embodiment, in which the pad to be attached is a PCM741 pad, the given temperature is chosen as being in the interval of 50° C to 70°C, for instance 60° C.

In at least an embodiment, the given temperature may be chosen just above the melting temperature of the pad, but close to this melting temperature (for instance 10 to 15 °C above the melting temperature), in order for the pad to become sticky but not to be completely melted during the heating.

In some embodiment, the heating conditions (heating tool, temperature, duration, ...) may be adapted to obtain a heated heat sink in a heated state such that, during the positioning, a second part of the pad may stay in a solid, or almost solid, state. For instance, the second part may be a lateral face or an opposite face, compared to the first part positioned on the heat sink. Such an embodiment may result for instance in a regular thickness and/or appearance of the positioning pad, and providing a uniform contact between the second part of the pad and a corresponding surface of the chip once mounted.

In other embodiments, the heating may be performed after the installation of the heat sink on the electronic card. It may be the case for instance in an embodiment in which the heat sink is being installed before the installation of the chip on the electronic card and is heated thanks to an air blowing tool.

In the illustrated embodiment of figure 2, the attaching method comprises a positioning 220 of at least a changing state pad in contact with the heated heat sink. The number of changing state pads that will be attached to the heat sink may for instance depend on the size and/or the shape of the heat sink and/or of the chip to be thermally protected.

In the embodiment illustrated by figure 1B, a changing state pad 112 is positioned on a surface 114 of the heat sink 110. In the particular embodiment of figure 1B, the pad is positioned on the center of a surface of heat sink 110 constituting a face of the heat sink. It covers partially the face 114 of the heat sink 110. In other embodiments, however, it may be positioned in another way, relatively of its position on the heat sink surface, notably in a corner of the surface. In other embodiments, eventually complementary, the pad may be positioned only partially on the face. This may be the case for instance when the pad size is greater than the size of the surface of the face on which it is to be positioned.

When several pads are positioned on a heat sink, the relative positions of the pads may be chosen in order to optimize the thermal conductivity of the set of pads.

Depending upon embodiments, notably when the positioning is performed by an automatic tool like a robot, the heat sink may be oriented differently depending upon embodiments during the positioning (so that for instance the surface 114 to be equipped with a pad is on a top face, as illustrated by figure 1B, or on a lateral face).

Depending upon embodiments, the positioning of the pad may be performed prior to the installation of the heat sink on an electronic card or just after the installation of the heat sink (if done immediately after the heating for instance).

According to the embodiment of figure 2, the positioning 220 is followed by a cooling 230 of the heat sink. This cooling 230 may be performed for instance by keeping the heat sink at ambient temperature or by blowing fresh or cold air on the heat sink, or by keeping it in a fresh, cold or freeze environment. A rapid cooling may permit for instance, in some embodiments, to limit the deformation of the pad.

This cooling 230 is optional.

Figure 2 also illustrates a mounting 250 of the heat sink on the chip to be protected thermally. The heat sink is mounted in an installation position where the pad attached to the heat sink is located, at least partially, between the heat sink and the chip to be thermally protected.

## Claims

1. A method for attaching at least a changing state pad to a heat sink configured to be mounted with at least an electronic chip, wherein said method comprises :
- heating said heat sink to at least a given temperature, bringing said heat sink to a heated state;
- positioning, while said heat sink is in said heated state, at least a first part of said changing state pad in contact with at least a surface of said heated heat sink, said surface being intended to face said chip once mounted.

2. An attaching method according to claim 1 wherein, at said given temperature, the changing state pad becomes, at least partially, soft enough to stick to the facing surface of the heat sink.

3. An attaching method according to any of claims 1 to 2 comprising cooling at least said surface of said heat sink and/or said first part of said positioned pad, in order to put said first part in a solid state.

4. An attaching method according to any of claims 1 to 3 wherein said positioning is performed prior to mounting said heat sink on a chip.

5. An attaching method according to any of claims 1 to 4 wherein, in said heated state, the heat sink is adapted for keeping a second part of said changing state pad, distinct from said first part, in a solid state.

6. An attaching method according to any of claims 1 of 5 wherein said heating is performed by heating said heat sink in a steamer.

7. An attaching method according to any of claims 1 to 6 wherein said heating is performed by blowing of hot air on at least said surface of said heat sink.

8. A heat sink configured to be mounted with an electronic chip, said heat sink comprising a changing state pad attached to said heat sink while said heat sink is in a heated state, in which it has at least a given temperature, at least a first part of said changing state pad being positioned in contact with at least a surface of said heated heat sink, said surface being intended to face said chip once mounted.

9. An electronic card wherein said electronic card comprises at least an electronic chip and at least a heat sink mounted with said electronic chip, said heat sink comprising a changing state pad attached to said heat sink prior to any operation of said electronic card, while said heat sink was in a heated state, in which it has at least a given temperature, at least a first part of said changing state pad being positioned in contact with at least a surface of said heated heat sink facing said chip once mounted with said chip.

10. An electronic device comprising at least an electronic card comprising at least an electronic chip and at least a heat sink mounted with said electronic chip, said heat sink comprising a changing state pad attached to said heat sink prior to any operation of said electronic card, while said heat sink was in a heated state, in which it has at least a given temperature, at least a first part of said changing state pad being positioned in contact with at least a surface of said heated heat sink facing said chip once mounted with said chip.
